# EUROPEAN PATENT SPECIFICATION

(11) **EP 3 068 207 B1**
(45) Date of publication and mention of the grant of the patent: **28.03.2018**
(21) Application number: 16157396.9
(22) Date of filing: 25.02.2016
(51) Int. Cl.: H05K 9/00, H04B 1/08, G06F 1/18, G06F 1/16

(54) **LIGHTWEIGHT ELECTRICAL ASSEMBLY WITH ENHANCED ELECTROMAGNETIC SHIELDING**
LEICHTGEWICHTIGE ELEKTRISCHE BAUGRUPPE MIT VERBESSERTER ELEKTROMAGNETISCHER ABSCHIRMUNG
ENSEMBLE ÉLECTRIQUE LÉGER AYANT DE MEILLEURES PROPRIÉTÉS DE BLINDAGE ÉLECTROMAGNÉTIQUE

(30) Priority: 12.03.2015 US 201514645901
(43) Date of publication of application: 14.09.2016
(73) Proprietor: Delphi Technologies, Inc., Troy, MI 48007 (US)
(72) Inventor: MADSEN, Wayne A., Kokomo, Indiana 46902 (US); JOHNSON, Brian W., Kokomo, Indiana 46902 (US)
(74) Representative: Robert, Vincent

(56) References cited:
- WO-A1-2012/125436
- WO-A2-2010/045397
- WILLIAMS, TIM: "EMC for product designers", REFEREX, 11 April 2007 (2007-04-11), XP040426156, ISBN: 0750681705
- ARMSTRONG K: "Review of EMC design rules, a brief tour of some of the major issues", 19990330, 30 March 1999 (1999-03-30), pages 1/1-112, XP006500695,

## Description

### TECHNICAL FIELD

The present invention relates generally to apparatus for enclosing electrical subassemblies, and more specifically relates to apparatus for efficiently securing subassemblies to a chassis of an electrical assembly such as an automobile audio system, navigational aid, personal computer, personal and telematic communication devices and the like.

### BACKGROUND OF THE INVENTION

Devices such as automobile audio systems or personal computers contain subassemblies such as circuit boards or disk drives that are attached to the chassis using threaded fasteners. The chassis provides structural support for the subassemblies and also provides electromagnetic shielding to limit electromagnetic interference (EMI) experienced by, and/or created by the device. The fasteners ensure that each subassembly within the chassis is properly located and securely retained within the chassis.

The use of such fasteners can have numerous drawbacks, particularly in a high volume production setting. The process for applying or installing fasteners can vary, but there is usually some degree of automation required, ranging from manually loading a screw into a bit on a pneumatic driver to using self-feeding automated machines. Typically, the torque applied by the device used to drive the fasteners must be monitored regularly and adjusted in order to assure proper seating of the fasteners. When fasteners are used, sheet metal tolerances, as well as tolerances of the fasteners themselves, have to be maintained at tight levels to allow for the minimization of stress in the assembly when aligning multiple fasteners with corresponding holes in the chassis and in the subassembly.

When threaded fasteners are used to assemble an electrical device, the assembly cycle time can be very long especially in high volume production. An operator assembling the device must typically first obtain the threaded fastener, orient and position it in alignment with the driver bit, then manipulate or actuate the machine to drive the threaded fastener. Furthermore, using threaded fasteners presents a risk of any one of the following upstream failures occurring: stripping of fastener threads; insufficient torque resulting in an unseated fastener; excessive torque resulting in distension/deformation of the fastener or adjacent electrical components; installation of the wrong fastener type or size; foreign object damage due to fasteners and/or metal shavings dropping onto the assembly and/or subassembly; and stripping of the head of the threaded fastener. Also, a fastener installation tool such as a driver and bit can slip off the fastener and impact an electrical component resulting in a damaged assembly.

If self-tapping fasteners are used, the process of driving the self-tapping fasteners into sheet metal often causes shavings of sheet metal to disperse into the assembly. Such shavings have been known to cause electrical failures, such as shorts or corruption of magnetic components that can permanently damage the product. If self-tapping fasteners are not used, an extra production step is required to pre-form threads in the sheet metal of the chassis and/or the subassembly to be installed within the chassis.

Fasteners further require an additional inventory burden on the production line in that the production line must be continuously stocked with part numbers (fasteners) other than the integral components that add value to the assembly. Also special tools specifically required for assembly, using fasteners, such as drivers and bits, must be continuously monitored and maintained for proper performance, wear and torque specifications. Typically, the top and/or bottom surface of the chassis must be secured in place after the subassembly is attached to the chassis.

Special fixtures are often required on the production line to secure a subassembly in a proper location and orientation while it is mounted within the chassis with fasteners. Such fixtures can be very complex, and the use of such fixtures usually requires extra handling of both the subassembly and of the resulting assembly thereby adding to the production cycle time and potentially compromising quality of the final product.

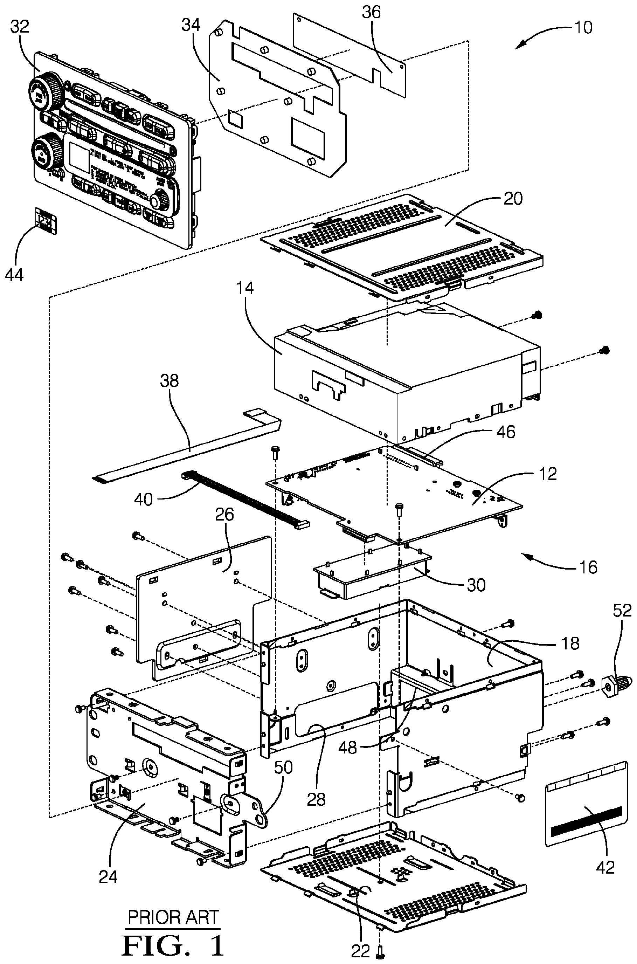

Figure 1 illustrates the construction of such an automotive audio device 10. The audio device 10 comprises a radio subassembly whose principle circuit components are carried on a circuit board 12. The circuit board 12 is encased within a folded common chassis 14 made up of a layered composite of plastic and wire mesh. The chassis 14 includes a wraparound housing 18 defining a back and components. sidewalls, a top cover 20, a bottom cover 22 and a front plate 24 which are interconnected by numerous threaded fasteners to collectively enclose the subassemblies. The top and bottom covers 20 and 22, respectively, are provided with large arrays holes or openings for airflow and ventilation of heat generated within the radio/CD player 10. A convector or heat sink 26 is carried on an outer surface of one of the chassis sidewalls and is interconnected through a port/window 28 to a power device assembly 30. A trim plate assembly 32, along with a support pad 34 and CD dust cover 36 are affixed to the front plate 24, providing an operator control interface with the radio/CD player 10. Circuit board 12 is electrically in-circuit with the CD player subassembly 14 through an intermediate flex wire cable 38 and with the power device assembly 30 through a jumper cable 40. Information bearing labels 42 and 44 are provided for future reference by the operator and service technicians. The radio/CD player 10 is electrically interconnected with an antenna, power supply, speakers and other related systems of a host vehicle by rear-facing connectors 46 carried on the circuit board 12 which are registered with openings 48 in the rear wall of wraparound housing 18. The radio/CD player 10 is mounted within a host vehicle by threaded fasteners passing through openings in mounting features 50 extending from front plate 24 and a rearwardly directed mounting bushing 52 which is threadably affixed to a stud (not illustrated) carried on the outer surface of the rear wall of wraparound housing 18. The shank of the stud extends outwardly through a hole disposed concentrically with a localized recess and the stud is seated within the recess. Another known stud design including a threaded shank secured to the rear wall of a radio set by a set nut and receiving a molded rubber, plastic or vinyl stud there over. Note the large number of threaded fasteners.

The radio/CD player 10 of Figure 1 is of ordinary complexity and may require fifty or more threaded fasteners to complete the manufacturing process. Installation of that many fasteners may require that the in-process chassis be repositioned/re-fixtured ten to fifteen times as it passes along an assembly line of eight to ten skilled workers/work stations.

Vehicle entertainment systems usually include an audio component such as a radio to enable receiving signals from antennas, contain various forms of playback mechanisms, and have the capacity to accept data from user devices like MP3 players. Typically, the radio has a decorative assembly that provides man-machine interface as well as displaying pertinent data relative to the selected media and audio settings. Also, the back-end or chassis is constructed of metal to provide various functions to ensure the performance of the radio in the vehicular environment. The structure to contain the mass from playbacks, the heat conductive properties, and the electrical shielding and grounding are just a few of the advantages to using the metal construction. Unfortunately, with the density of the metal, the disadvantage of added weight is a side effect of the typical construction. In a vehicle, added weight impacts fuel economy, as well as other hidden costs during assembly that can effect the cost of the product, like sharp edges of metal can be a potential hazard for assemblers in the manufacturing plant as well as added weight can limit the packaging of multiple parts in containers for inter and outer plant distribution.

Devices such as automobile stereos, audio amplifiers, home stereo systems, two-way radios, computers, signal conditioners/amplifiers, compact disc playing mechanisms, and cassette tape playing mechanisms are examples of products that typically require electrical components to amplify signals and regulate power. Accordingly, such devices typically contain numerous electrical components such as single in-line package (SIP) amplifiers and regulators that are typically soldered into printed circuit boards. Such electrical components generate heat in use. The heat must be dissipated away from the electrical components to avoid damage that can be caused by excessive temperatures in the electrical components. For example, excessive temperatures can cause delicate electrical leads to fail or insulating materials to melt, thereby causing a short circuit resulting in damage to, or even failure of, the entire electrical device.

A convector is often mounted to an outer surface of such a device to dissipate heat generated by components by transferring the heat away from the components and the device to the convector and then to the air through radiation. In order to accomplish this, it is preferable that the convector be physically in contact with the component. The components and the convector can be pressed together to allow even better heat conduction from the components to the convector. Sometimes an intermediary material such as a thermal pad or silicon grease is used between the component and the convector to assist in creating an adequate heat transfer junction.

Many convectors are made from aluminum due to the high heat conductivity of that material. Convectors often include a plurality of fins to increase the effective surface area of the convector and thereby increase the rate at which the convector can dissipate heat. Typically, aluminum, convectors are formed by an extruding process, during which the fins can also be formed integrally therewith.

Convectors are usually assembled to the component or components during final assembly of the overall device in which they are used. At final assembly, components such as SIP amplifiers are already soldered into a printed circuit board. The order of assembly can vary as to which component is assembled into the chassis first. The printed circuit board can be installed into the chassis before the convector is mounted to the printed circuit board and the chassis. Alternatively, the convector can be mounted to the chassis before the printed circuit board is mounted to the convector. Sometimes, the convector is assembled to the printed circuit board to form a subassembly before being assembled to the chassis.

Typically, components are attached to the convector using a clip and one or more threaded fasteners that extend through a hole in the clip and into a hole in the convector. The clip, component and convector must all be simultaneously held in a fixture and then be fastened together with a threaded fastener. If the component includes a hole to accept a threaded fastener, it can be mounted directly to the convector using a threaded fastener that extends through that hole, without using a clip.

The use of such fasteners can have numerous drawbacks, particularly in a high volume production setting. Often, each hole in the convector that receives a fastener must be separately drilled or punched. This is especially true for an extruded convector if the axis of the hole is not aligned with the direction in which the convector is extruded. The fastening process can vary, but there is usually some degree of automation required, ranging from manually loading a screw into a bit on a pneumatically or electrically powered driver to using self-feeding screw machines. Typically, the torque applied by the device must be monitored regularly and adjusted in order to assure proper seating of the fasteners.

The clamping force between the convector and the component should be at a proper level to ensure sufficient heat transfer to the convector. When fasteners are used to attach the convector to the component, clamping force is a function of the type of fastener and its condition and degree of assembly (e.g. the level of torque applied during installation of the fastener). Thus, a threaded fastener that is not seated all the way will give less clamping force than one that is seated all the way. Or, a stripped or improper type of fastener may provide an insufficient clamping force.

Special fixturing is often required to hold a component in the proper location while it is mounted to the convector using one or more fasteners. Such fixturing can be very complex and use of such fixturing usually requires extra handling of both the component and of the resulting assembly, thereby adding to the production cycle time and potentially compromising quality of the final product.

When threaded fasteners are used, the assembly cycle time can be very long, especially in high volume production. The operator must specifically obtain the threaded fastener, bring it in contact with the driver bit, then drive the threaded fastened. If self-tapping fasteners are used, the process of driving the self-tapping fasteners into metal often causes metal shavings to disperse into the assembly. Such shavings have been known to cause electrical failures that can permanently damage the product. If self-tapping fasteners are not used, an extra production step is necessary to form threads in the metal of the convector.

Accordingly, there is a need for electrical assemblies that do not require fasteners or tooling for securing a component to a convector.

Vehicular radio chassis assemblies may typically contain a circuit board assembly and a playback mechanism that may have ground points from the circuit board to the enclosure. They also tend to have heat sinks added for conducting unwanted heat away from the radio circuit board power components to transfer the heat outside of the chassis. When the enclosure has been constructed of a non-metallic material such as plastic, the grounding and shielding has been provided by a variety of methods, including, but not limited to using a metal wire mesh that is insert molded with the structure of the plastic enclosure. Another method may include using localized shields that are assembled and soldered to the circuit board. However, this approach only provides a shield, not a ground. While plastic enclosures are desirable for manufacturing assembly simplification through the elimination of fasteners as well as weight reductions from the metal enclosures, the capitalization to provide a wire mesh insert to a plastic part has been a drawback, especially in low volume applications. Also, the manufacturing process flow has typically coupled the wire mesh insert fabrication cell directly with the plastic molding press, which may not be desired is the molding process utilization is not at a high enough percentage of the available molding press time.

Static electricity (electrostatics) is created when two objects having unbalanced charges touch one another, causing the unbalanced charge to transfer between the two objects. This phenomenon commonly occurs in homes, vehicles and other environments when the air is dry (i.e. has a characteristic relatively low level of humidity). For instance, when a person slides onto a car seat, electrons may transfer between the two, causing the surface of the person's body to store a charge. When the person, then, touches a vehicle component, the charge may travel (discharge) from the body to the component, thus creating static electricity. If the object touched is an electronic device, such as a home stereo, home theatre system, computer, vehicle entertainment system or other electronic media system, this electrostatic discharge can be harmful to the sensitive electronic components of the device. For instance, when a person slides onto a vehicle seat and inserts a disc into the car stereo, a charge may travel from the body through the disc to the sensitive electronic components in the vehicle stereo. Similar problems may occur when using DVD and other magnetic media and disc players. Document WO2012/125436A1 relates to apparatus for enclosing electrical subassemblies. Document WO2010/045397A2 relates to EMI-Shielding Solutions for Electronics Enclosures Using Opposing Three-Dimensional Shapes and Channels Formed in Sheet Metal.

Accordingly, problems with the drainage of a static electric charge impacting sensitive electronic components continue to persist.

### SUMMARY OF THE INVENTION

The present invention provides numerous product and process advantages which collectively result in substantial cost and labor savings. By way of example, the preferred design optimizes the assembly process. It minimizes the required handling of major components and subassemblies during the assembly cycle. Final assembly is optimized, wherein only seven major components and subassemblies are involved. This minimizes the number of work stations and fixtures, in-process transfers between work stations and total assembly cycle time. The inventive design permits selection of the optimal mechanical product configuration for a given receiver family. Furthermore, it permits idealized electrical and mechanical building block partitioning for common and unique elements.

The present invention represents a significant improvement in RFI isolation when applied in lightweight electrical assemblies such as those employing fold-up cases formed as a preform blank consisting of at least one layer of relatively rigid polymer material and at least one layer of electrically conductive material capable of shielding said electrical circuit assembly from electrical anomalies. In the presently improved configuration the wall panels are folded to isolate any resulting gaps exposing the vulnerable electrical circuit assembly.

One embodiment of the invention contemplates screwless final assembly without the use of tools, fixtures and assembly machines. This greatly enhances in-process product flow in the factory, improves scheduling of final assembly, and allows labor intensive processes such as stick lead assembly to be largely moved off-line. This greatly reduces both direct and indirect labor requirements. Furthermore, inventory control is simplified inasmuch as position part proliferation is deferred to or near the end of process.

These and other features and advantages of this invention will become apparent upon reading the following specification, which, along with the drawings, describes preferred and alternative embodiments of the invention in detail.

### BRIEF DESCRIPTION OF THE DRAWINGS

The present invention will now be described, by way of example, with reference to the accompanying drawings, in which:
FIG. 1, is an exploded, perspective view of a prior art automotive radio/CD player combination in a common chassis constructed of sheet metal and a large number of threaded fasteners;
FIG. 2, is an exploded, perspective view of a preferred embodiment of the present invention implemented as a radio assembly, illustrating the major subcomponents and subassemblies thereof;
FIG. 3, is a perspective view of a generally planer two-dimensional preform blank as formed, such as by injection molding, prior to beginning the final assembly process;
FIG. 4, is a perspective view of the radio assembly of Figure 2, illustrating final assembly step I in the production thereof wherein a circuit board assembly is slid and snapped to the inner surface of the front wall portion defined by the preform blank of Figure 3;
FIG. 5, is a perspective view of the radio assembly of Figure 2, illustrating final assembly step II in the production thereof wherein three series arranged wall portions (bottom, back and top offset) defined by the preform blank of Figure 3 are simultaneously folded by rotation about a first living hinge aligned on an axis V from a horizontal orientation illustrated in Figure 3 to a substantially vertical orientation;
FIG. 6, is a perspective view of the radio assembly of Figure 2, illustrating final assembly step III in the production thereof wherein the remaining two wall portions (top and shield fence) defined by the preform blank of Figure 3 are simultaneously folded by rotation about a second living hinge aligned on axis Y from a horizontal orientation illustrated in Figure 3 to a substantially vertical orientation parallel to the bottom, back and top offset panels of Figure 5;
FIG. 7, is a perspective view of the radio assembly of Figure 2, illustrating final assembly step IV in the production thereof wherein the shield fence wall portion defined by the perform blank of Figure 3 is folded by rotation about a third living hinge aligned on axis Z from a vertical orientation illustrated in Figure 6 to a substantially horizontal orientation parallel to the front wall portion;
FIG. 8, is a perspective view of the radio assembly of Figure 2, illustrating final assembly step V in the production thereof wherein the remaining wall portions (back and top offset) defined by the perform blank of Figure 3 are folded simultaneously by rotation about a fourth living hinge aligned on axis W from a vertical orientation illustrated in Figure 7 to a substantially horizontal orientation parallel to the front wall portion;
FIG. 9, is a perspective view of the radio assembly of Figure 2, illustrating final assembly step VI in the production thereof wherein the remaining wall portion (top offset) defined by the preform blank of Figure 3 is folded by rotation about a fifth living hinge aligned on axis X from a horizontal orientation illustrated in Figure 8 to a substantially vertical orientation coplanar with top wall portion, thus forming the case into a three dimensional configuration;
FIG. 10, is a perspective view of the radio assembly of Figure 2, illustrating final assembly step VII in the production thereof wherein the trim panel assembly is snapped to the outer surface of one of the four wall portions, specifically the front wall portion, defined by the preform blank of Figure 3;
FIG. 11, is an exploded, perspective view of the radio assembly of Figure 2, illustrating final assembly step VIII in the production thereof wherein the discrete left and right side wall closure members are installed via snap-fit engagement features and thermally coupled with power devices carried with the circuit board assembly;
FIG. 12, is a cross-sectional view of a prior art automotive electrical enclosure assembly including a housing formed as a composite two-dimensional preform blank which is folded to form a three-dimensional enclosure which shields and grounds an electrical assembly contained therein;
FIG. 13, is a perspective view of an alternative embodiment of the present invention implemented as an improved automotive electrical enclosure assembly including a housing formed as a composite two-dimensional preform blank which is folded to form a three-dimensional enclosure which shields and grounds an electrical assembly contained therein;
FIG. 14, is a cross-sectional view of the alternative embodiment of the present invention of Figure 13 illustrating the inter-fit of the electrical assembly within the enclosure assembly;
FIG. 15, is a top plan view of the electrical assembly of the automotive electrical enclosure assembly of Claim 14; and
FIG. 16, is a bottom plan view of the electrical assembly of the automotive electrical enclosure assembly of Claim 14 juxtaposed with an adjacent wall portion (e.g., front panel) of the enclosure.

Although the drawings represent varied embodiments and features of the present invention, the drawings are not necessarily to scale and certain features may be exaggerated in order to illustrate and explain the present invention. The exemplification set forth herein illustrates several aspects of the invention, in one form, and such exemplification is not to be construed as limiting the scope of the invention in any manner.

### DESCRIPTION OF THE ILLUSTRATIVE EMBODIMENTS

In the following Detailed Description, reference is made to the accompanying drawings, which form a part thereof, and in which is shown by way of illustration specific embodiments in which the disclosure may be practiced. In this regard, directional terminology, such as "top", "bottom", "front", "back", "leading", "trailing", etc. is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. Furthermore, the axes (e.g., ±X, ±Y, and ±Z axes) are referenced on the drawings to provide a relative directional sense only. The following detailed description, therefore, is not to be taken in a limiting sense, and the scope of the present invention is defined by the appended claims.

For purposes of providing non-limiting definition and to enable clear understanding of the present disclosure, "longitudinal" means parallel to the direction of the Y axis, "lateral" means parallel to the direction of the X axis, and "vertical" means parallel to the direction of the Z axis.

The present invention can be applied in its broadest sense to electronic devices and systems where shielding from radio frequency interference (RFI), electromagnetic interference (EMI), bulk current injection (BCI) and/or electrostatic discharge (ESD) is required. In addition to vehicle based radios and audio entertainment systems, the invention can be advantageously applied in "infotainment" and telematic systems. Furthermore, the present invention employs virtually "fastenerless" design architecture to facilitate low-cost, high volume production techniques.

A telematics product is a two-way communication/receiver system that enables access by a vehicle occupant to vehicle related information like geographic position/ location through the use of a GPS module with antenna, vehicle diagnostics, crash sensors and air bag deployment. It also contains a phone module that is linked through a microphone in the vehicle and the radio speaker system for hands free calling via voice recognition and links to a call center for a variety of services, including but not limited to emergency help, concierge, vehicle theft recovery, turn-by-turn route guidance, vehicle diagnostics and vehicle unlock.

Recently, the assignee of the present application has developed a proprietary lightweight audio system which employs molded plastic incorporating various mechanical features useful for housing an electronic assembly but includes a composite structure including conductive wire mesh to facilitate EMC shielding. The housing is initially molded as a flat sheet and subsequently folded to form a final three-dimensional enclosure. The conductive mesh is continuous along the folded edges, but where the open edges of the panels meet, there is no natural connectivity.

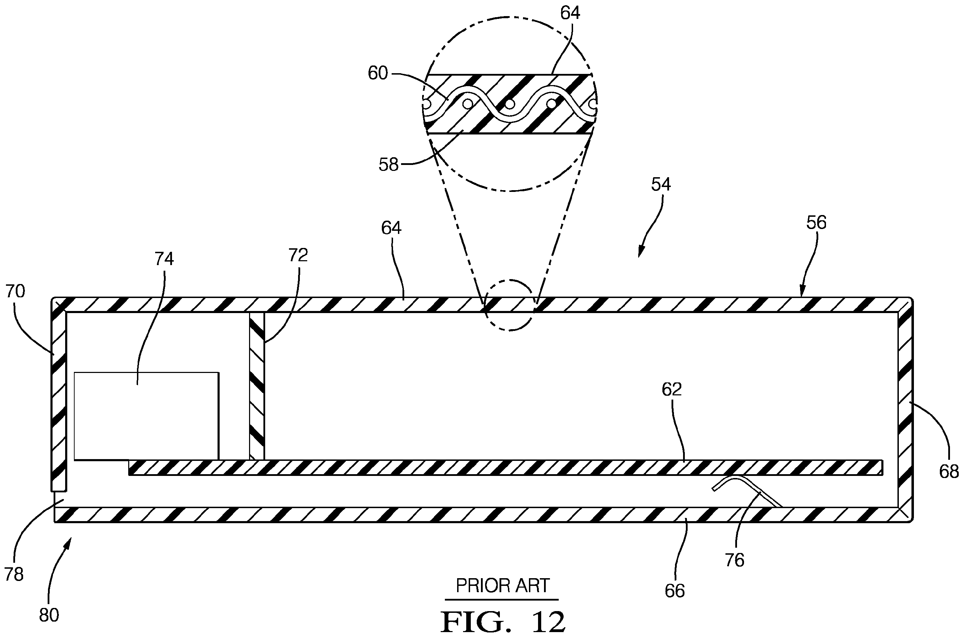

Looking at a side view of the enclosure, a known mesh enclosure has a configuration whereby the mesh continuously traverses along the bottom of the PCB, "wraps around" up the back, across the top, contacts the shield-fence and finally folds down over the connector area. Appropriate openings can be provided for wire harness connector access. The mesh is exposed in several areas, along the edges but several "cantilever arms" can be added to provide electrical contacts to the PCB and side panels. However, due to the folding of the panels, there is a resultant slot along the entire length where the mesh is not connected. Additionally, there are no connections of the mesh to the PCB, especially along the connector side of the enclosure. This leaves an un-protected area from a shielding effectiveness standpoint where a complete Faraday shield is needed to provide adequate EMC performance. Refer to the lower left portion of the electrical assembly illustrated in Figure 12.

Referring to Figure 12, an electrical assembly 54 includes a housing 56 injection molded as a composite consisting of a plastic layer 58 and electrically conductive wire mesh 60, which is folded to enclose and shield an electronic device 62. The housing 56 forms top and bottom panels 64 and 66, respectively, a back panel 68 and a front panel 70, integrally formed by living hinges enabling folding into a box-like shape. The wire mesh 60 traverses along the bottom panel 66 beneath the printed circuit board (PCB) of the electronic device 62, extends around the back panel 68 and along the top panel 64 atop the PCB where it contacts a shield-fence 72 and finally extends around the front panel 70 enclosing the connector area 74. Appropriate openings are provided for wire harness connector access. The wire mesh 60 is exposed in several areas along the edged. In addition, several cantilever arms 76 can be added to provide electrical contacts between the PCB and the side panels (not illustrated). However, due to the folding of the panels, there is a resulting lateral slot 78 between the adjacent terminus of the bottom and front panels 66 and 70, respectively, extending the entire width of the housing 56 where the mesh is not locally connected. Additionally, there are no connections of the mesh 60 to the PCB, especially along the connector side of the housing enclosure 56. This can leave an unprotected area 80 from a shielding effectiveness standpoint where a complete Faraday shield is needed to provide superior EMC performance.

For convenience of understanding, the following description will be focused primarily upon a lightweight automotive audio (i.e., radio) system.

The present invention reflects an improved design to reduce the overall weight of an automotive radio without compromising the strength of the unit. The present invention employs a polymer based material that can be molded to provide the necessary features for the chassis as well as the frontal interface to the decorative front-end assembly described for the man-machine interface. By molding a case with the necessary details to accept the playback mechanisms (if desired) as well as the circuit board(s) needed for the electrical control, the required functionality of the unit is maintained as compared to the typical metal box. The necessary shielding and grounding is accomplished by insert-molding a mesh screen wire that has been pre-formed to contour with the molding operation. The grounding of the circuit boards may be accomplished by using ground clips attached directly to the ground pads of the circuit board that would interface directly with exposed screen wire mesh of the molded part. While metal is also a good conductor for the thermal load inside the unit, openings must be incorporated to allow airflow for additional cooling. The same openings can compromise the shielding. With in-molded mesh screen wire, the mesh acts as a Faraday cage to shield the electronics, but the open weave allows airflow to promote the dissipation of the thermal load from inside the unit, to the exterior. Besides the reduction of mass offered by the molded polymer material for the unit chassis and front plate, the hidden benefits include ease of handling in the assembly process as well as less container and shipping weight.

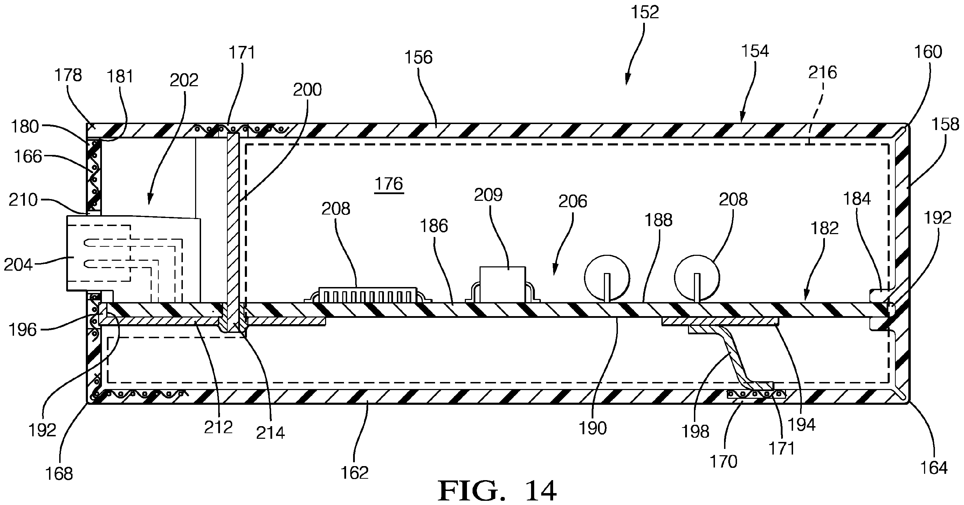

In the presently improved configuration, the panel enclosing the connector area at the bottom instead of the top as illustrated in Figure 14. This design incorporates Mesh-to-PCB contacts along the edge of the PCB in the connector area. Note that the vehicle connector pins are bypassed to the ground plane of the PCB with the ground plane of the PCB and the shield-fence completing the Faraday cage providing a barrier for immunity and emissions. The unconnected edge of the mesh is now along the upper left edge where, at this location, there is no effect on the integrity of the Faraday cage.

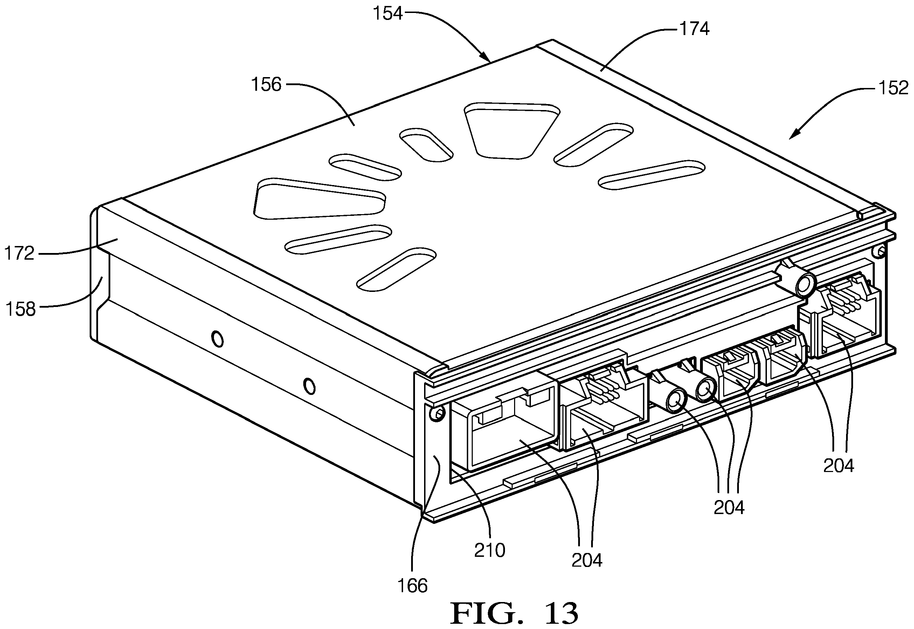

The Mesh-to-PCB contacts can be implemented in a number of potential means such as EMC gasket material, conductive spring clips, or other commonly used EMC contact technologies. An additional feature of the present invention is to incorporate Mesh-to PCB contacts by utilizing PCB edge plating (contacting through openings in the plastic to allow contact to the mesh). A significant feature of the Mesh-to-PCB contacts utilizing the PCB edge plating contact is to provide a configuration that does not require any separate added components or assembly operations. The side panels shown in Figure 13 can also benefit from the presently described configurations by connecting to the PCB edges.

The major changes for the present improved embedded mesh configuration includes: (1.) incorporating a fully enclosed Faraday cage for improver EMC isolation, (2.) provides PCB-to-Mesh contacts along the otherwise open edge where the folded panels meet, and (3.) utilizes plated PCB-edge-to-Mesh contacts which can be implemented without adding extra components or handling operations vs. adding standard EMI contacts, gaskets and the like.

To facilitate assembly, the molded polymer chassis and front plate can use integral or molded in guideways and snaps, thereby eliminating the typical screw fastener assembly method previously used for these components. To enhance the rigidity, the component parts that comprise the assembly are sandwiched at the common vehicle instrument panel attachment points such that when the mounting screws are driven, they firmly clamp the component pieces to the host vehicle. In the event a playback mechanism of substantial mass and volume is required, the sub-assembly structure for the mechanism would utilize formed attachment tabs that would be an intermediate layer in the aforementioned component part sandwich. Another benefit for the mounting at the back of the radio is often vehicles have a receptive hole or slot in the inner cavity of the instrument panel carrier that accepts a mounting bushing or "bullet" shaped extension that is screwed to a mounting stud that is typically swaged to the back of the metal enclosure of the radio. The mounting "bullet" can be molded directly in the polymer-based case eliminating the additional part and the assembly of that additional part.

To replace the metal structure of the vehicle radio, a galvanized (or appropriately coated) steel mesh wire screen will be cut, formed, and molded with a polymer resin to provide necessary details for assembly of components required for the functionality of the radio including, but not limited to, a circuit board assembly, a heat sink for audio power and switching components, a playback mechanism, and a man-machine interface or trim plate assembly, as well as vehicle mounting features. While the polymer or plastic provides the majority of the mechanical structure for the radio, the in-molded mesh screen wire provides the needed protection from various electrical anomalies including electromagnetic contamination, radio frequency interference, bulk current injection, and electrostatic discharge, to name a few. The screen mesh also allows openings necessary for air passage or venting of heat from the radio by molding the radio back end or case and front plate. The many details and features needed in a typical assembly can be incorporated directly into the parts, eliminating the need for fasteners and separate additional parts often required with parts fabricated in metal.

The specific materials selected for fabricating the radio case and front plate will vary depending upon the application, including the contained mass of the mechanisms employed as well as the severity of the contemplated environment (esp. temperature and vibration). Examples of materials that could be employed for typical automotive applications are:
Case: Glass-filled polyester, Glass-filled polypropylene, Polycarbonate, ABS.
Front Plate: Polycarbonate, ABS, PC/ABS and Noryl.

Major components which contact one another or are mechanically interconnected preferably are formed from material having substantially differing surface finish and hardness characteristics to minimize the possibility of resulting squeaks, rattles and the like.

Although presently viewed as cost prohibitive for automotive applications, it is contemplated that nano carbon tube filler can be employed within the plastic material forming the case and front plate to provide effective shielding and enhance the structural strength of the case assembly.

In addition to weight savings, which may amount to well over one pound (0.4536 Kg), the part handling is improved to reduce the amount of fasteners as well as separate component parts. Often a radio may be constructed from a wraparound, a cover and the fasteners along with a mounting bushing or "bullet" screwed to a "swaged" threaded stud in the metal case. Also, the metal pieces require assembly personnel to wear gloves during handling to avoid any cuts or damage to their hands as well as protection from any metal fabrication fluid residue. Molded plastic does not require any special gloves, or the concerns of cuts to the skin. Aside to the benefit to the vehicle by reducing the radio weight by over one pound (0.4536 Kg), the savings for a manufacturer include reduced shipping cost through the weight reduction and potential container efficiency improvements. Product labeling can be improved through laser engraving the plastic with the desired number, customer logos, etc. Metal typically requires a stamping detail (not easily changed) and/or a printed label that is adhesively applied. This offers greater flexibility and eliminates additional parts (like labels) to use the plastic, as well as better durability than a label.

The applicant has developed enclosure technologies utilizing molded plastic incorporating various mechanical features useful for housing an electronic assembly and including embedded conductive mesh to facilitate EMC shielding. The housing is molded as a flat sheet and folded to form the ultimate 3D (i.e., three dimensional) enclosure. The conductive mesh is continuous along the folded edges, but where the open edges of the panels meet, there may be no natural connectivity.

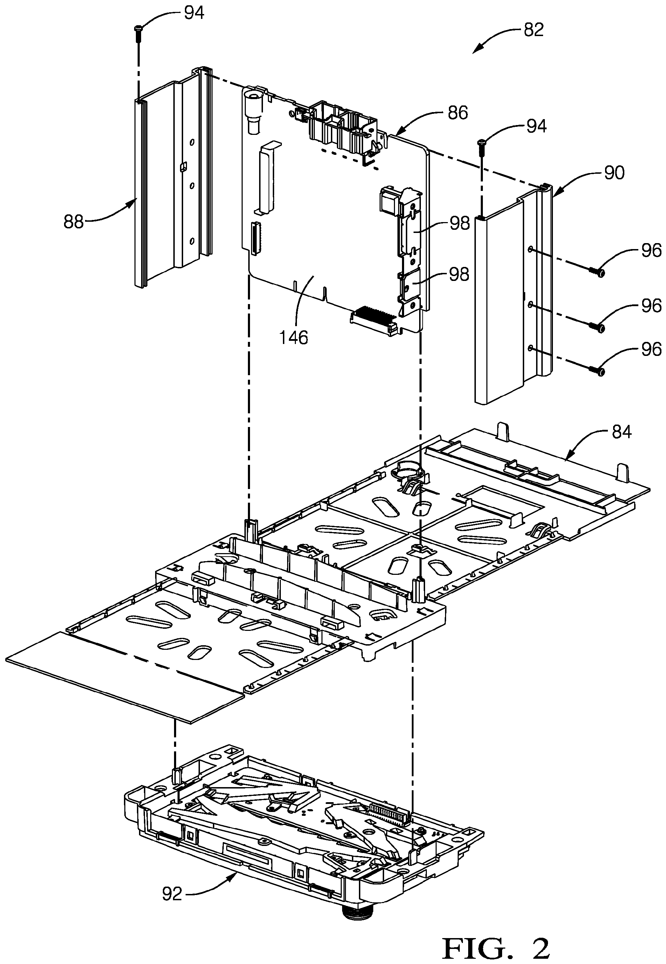

Referring to Figure 2 - 11, a light-weight audio system 82 embodying many aspects of the present invention is illustrated. The audio system 82 is an assemblage of five major components or subassemblies, a generally planer, composite preform blank 84, a circuit board subassembly 86, a left side closure member 88, a right side closure member 90 and a trim plate subassembly 92. As will be described in greater detail herein below, rear panel reinforcement screws 94 are affixed to the rear edges of the left and right side closure members 88 and 90, respectively, and screws 96 affix the right side closure member 90 directly to power devices 98 mounted on the circuit board subassembly 86.

It is envisioned that each of the major components/subassemblies would be produced "off-line" and the final assembly process would comprise the efficient, high volume joining of the major components/subassemblies and end-of-line testing of the completed units.

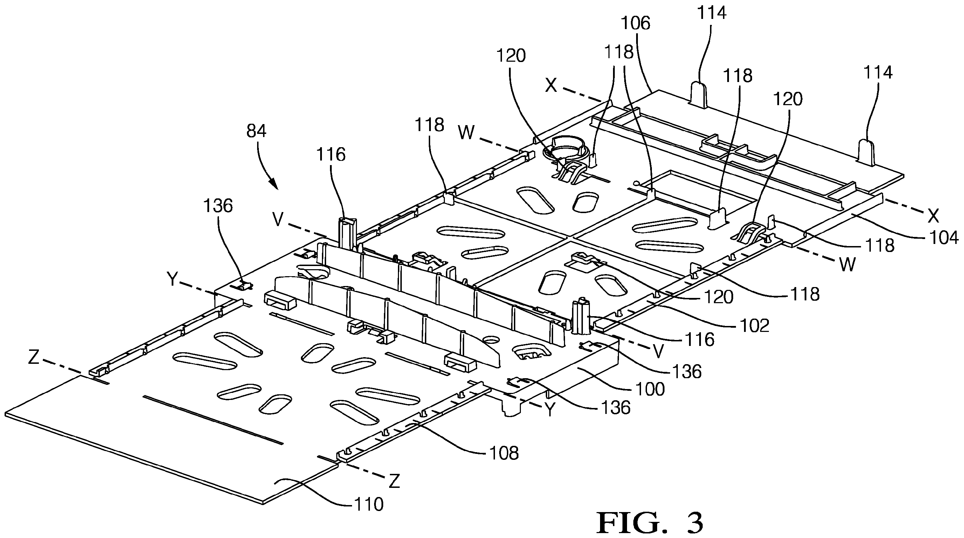

Figure 2 is an exploded view illustrating the juxtaposition of the respective major components during the assembly process. Figures 3 - 11 depict specific assembly steps of the major components as will be described herein below.

As best seen in Figure 3, the preform blank 84 is preferably injection molded of polymer based material in a generally planer configuration and, when finally assembled, forms a box-like, three dimensional case. The blank 84 defines a front wall portion 100, a bottom wall portion 102, a rear wall portion 104 and a top closure wall portion 106 integrally interconnected by "living hinges" extending along axes designated as V - V, W - W and X - X, respectively. The blank 84 further defines a top wall portion 108 and a shield wall portion 110 also integrally interconnected with the front wall portion 100 by "living hinges" extending along axes designated as Y - Y and Z - Z, respectively. All of the blank wall portions are integrally formed in a single injection molding process and comprises a composite of a pre-shaped planer piece of wire screen wire insert molded within a layer of relatively rigid polymer material such as glass filled polypropylene. Each of the wall portions is deemed to have a leading edge, a trailing edge and an opposed pair of side edges.

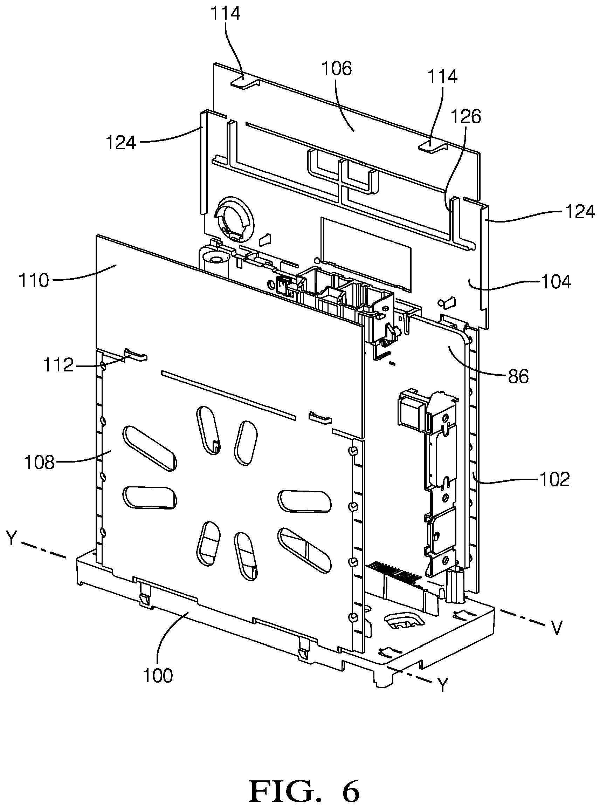

As best viewed in Figures 6 - 8, the shield wall portion 110 has a pair of female guide features 112 integrally formed adjacent the trailing edge thereof along hinge line Z - Z. Similarly, the top closure wall portion 106 has a pair of male guide features 114 integrally formed adjacent the leading edge thereof. Upon final assembly, the leading edge of the top closure wall portion 106 is interconnected with the trailing edge of the shield wall portion 110 adjacent hinge line Z - Z.

The trailing edge of the bottom wall portion 102 is interconnected with the bottom edge of the front wall portion 100 along hinge line V - V. The trailing edge of the rear wall portion 104 is interconnected with the leading edge of the bottom wall portion 102 along hinge line W - W. The trailing edge of the top closure wall portion 106 is interconnected with the leading edge of the rear wall portion 104 along hinge line X - X.

Similarly, the trailing edge of the top wall portion108 is interconnected with the top edge of the front wall portion 100 along hinge line Y - Y. The trailing edge of the shield wall portion 110 is interconnected with the leading edge of the top wall portion 108 along hinge line Z - Z.

With the exception of differences set forth herein below, the circuit board subassembly 86 and trim plate subassembly 92 are substantially similar to the corresponding major components described in US 8,375,575 B2, which has been incorporated herein by reference. For the sake of brevity, the details thereof will not be repeated here.

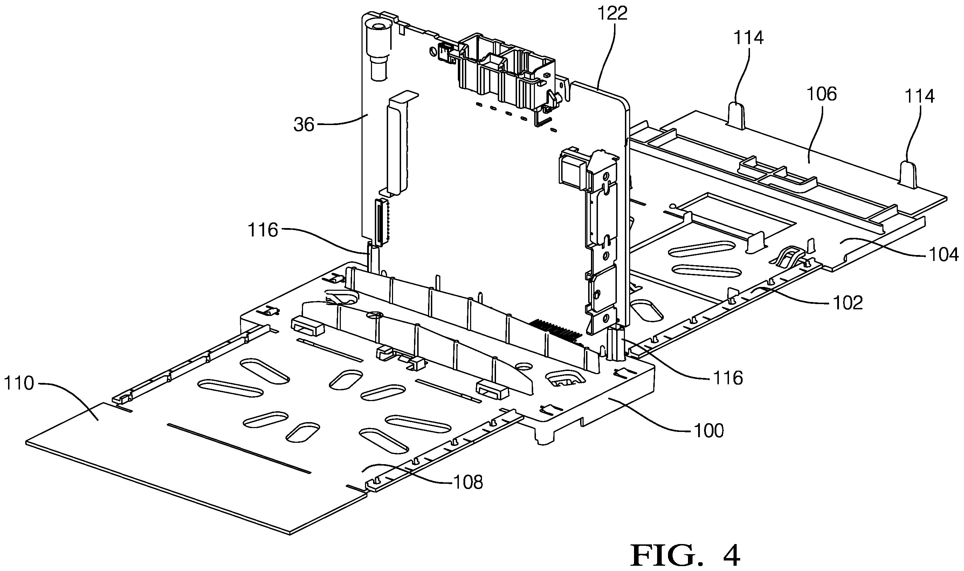

Referring particularly to Figures 4 - 11, a method of assembly of the lightweight audio system 82 of the present invention is illustrated. Audio system 82 can be assembled manually by an ordered process wherein a single (preferably, but not limited to) operator, who sequentially assembles the five major components or subassemblies on a designated work surface. No specialized tools or separate/dedicated fixtures are required. No threaded fasteners/screws are required, except as expressly described. Each or the major components and subassemblies form integral features which cooperate to interact with features of the other components and subassemblies to register, align and guide the components and subassemblies during adjoining thereof as well as to removably affix the components and subassemblies to one another when in their final design position. This process is referred to herein as the Slide-lock Snap-lock™ Screwless Assembly Technology and Method or "SLAT". In effect, the components "self-fixture" one another in combination. The assembly of the audio system is effected by the assembly technician or operator taking the following steps:

Referring to Figure 4, the circuit board subassembly 86 is inserted downwardly to self-align, self-position and self-engage with guide ways integrally formed by extensions 116. In-so-doing, the electrical circuitry contained on the circuit board subassembly 86 is juxtaposed for subsequent electrical interconnection with the circuitry on the trim plate subassembly 92, as well as the other components via registering interconnects and plugs (not illustrated).

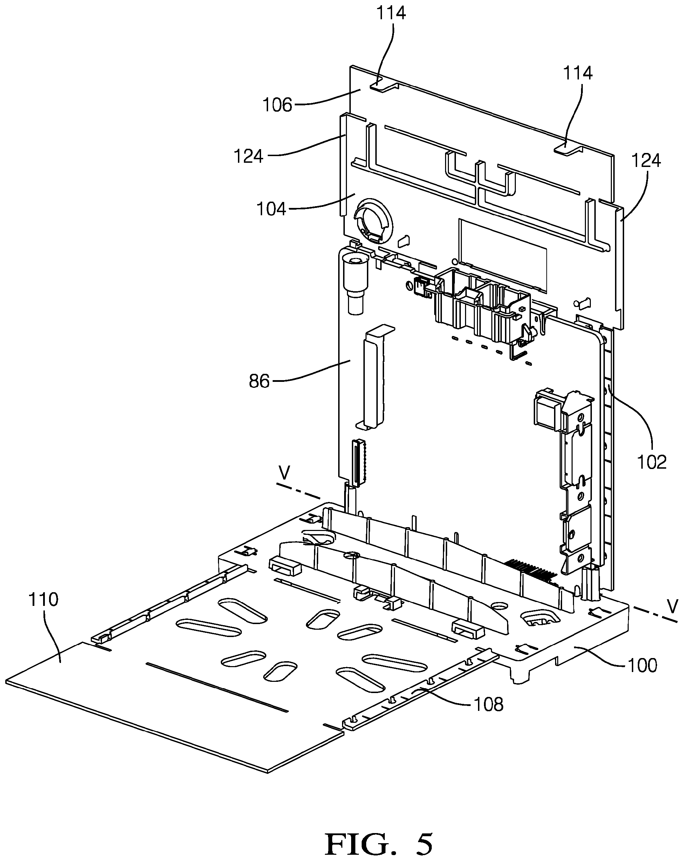

Referring to Figures 5 - 9, the preform blank 84 is then folded, transitioning it from its original generally planer configuration to a three dimensional box-like configuration. Referring to Figure 5, the first step of folding the preform blank 84 entails manually or mechanically rotating bottom wall portion 102 substantially 90° about axis V - V from its original horizontal orientation illustrated in Figure 4 co-planer with the front wall portion 100 to a vertical orientation substantially perpendicular or normal with front wall portion 100. Note that in this step, rear wall portion 104 and top closure wall portion 106 remain co-planer with bottom wall portion 102, assuming a vertical orientation.

Referring to Figure 6, the second step of folding the preform blank 84 entails manually or mechanically rotating top wall portion 108 substantially 90° about axis Y - Y from its original horizontal orientation illustrated in Figure 4 co-planer with the front wall portion 100 to a vertical orientation substantially perpendicular or normal with front wall portion 100. Note that in this step, shield wall portion 110 remains co-planer with top wall portion 102, assuming a vertical orientation.

As best viewed in Figure 3, the inner surface of the bottom wall portion 102 has integrally formed inwardly directed guide retainer features 118 which, in combination with the grounding clips 120, function to position, secure and electrically ground the circuit board subassembly 86 upon final assembly of the light-weight radio system 82. The guide retainer features 118 positionally secure the circuit board subassembly 86 by engaging side edges and slots 122 formed therein.

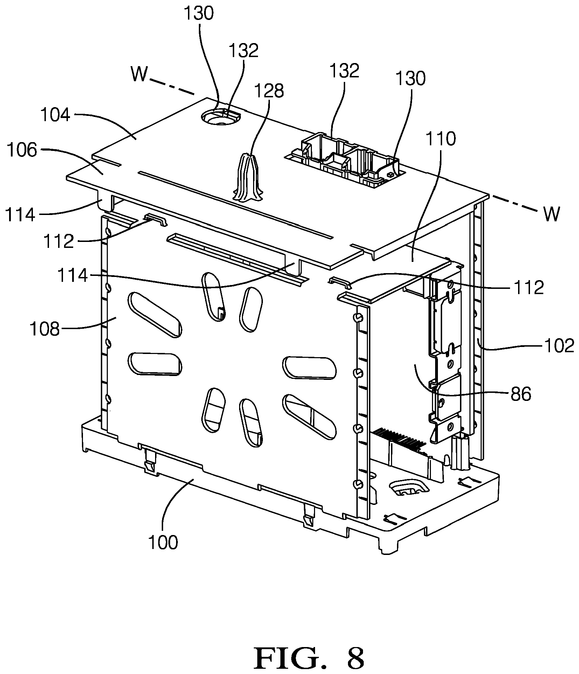

Inwardly directed, laterally opposed edge retention ribs 124 are integrally formed on the inner surface of the rear wall portion 104. Furthermore, integral reinforcing ribs 126 extend from the inner surface of the rear wall portion 104 to secure a rear integral mounting stud 128 extending from the outer surface of the rear wall portion 104. See Figure 8. Similarly, the inner surface of the top wall portion 108 has X-shaped reinforcement ribs (not illustrated) integrally formed on the inner surface thereof to prevent "oil canning".

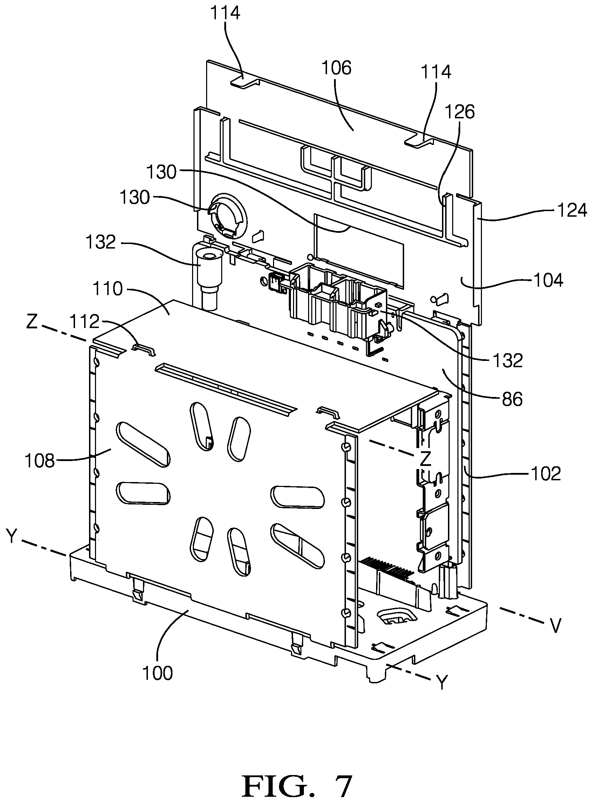

Referring to Figure 7, the third step of folding the preform blank 84 entails manually or mechanically rotating shield wall portion 110 substantially 90° about axis Z - Z from its vertical orientation illustrated in Figure 6 co-planer with the top wall portion 108 to a horizontal orientation substantially parallel with front wall portion 100. Note that in this step, the leading edge of the shield wall portion 110 engaged the printed circuit board 86, establishing electrical and mechanical interconnection therewith, as will be described in greater detail herein below. Although not illustrated, after completion of the step of Figure 7, guide retainers 118 serve to abut the rearmost edge surface of the circuit board subassembly 86 to affect longitudinal support thereof.

Referring to Figure 8, the fourth step of folding the preform blank 84 entails manually or mechanically rotating rear wall portion 104 substantially 90° about axis W - W from its vertical orientation illustrated in Figure 7 co-planer with the bottom wall portion 102 to a horizontal orientation substantially parallel with front wall portion 100. Upon folding the rear wall portion 104 to the position illustrated in Figure 8, shaped apertures 130 formed in the rear wall portion 104 register with standard connector assemblies 132 provided along the rear edge of the circuit board assembly 86 for interfacing the audio system 82 with speakers, ground, power, antennas and associated control/readout systems via wire harnesses. Note that in this step, top closure wall portion 106 remains co-planer with rear wall portion 104, assuming a horizontal orientation. Although not illustrated, after completion of the step of Figure 8, guide retainers 118 serve to abut the rearmost edge surface of the circuit board subassembly 86 to affect longitudinal support thereof.

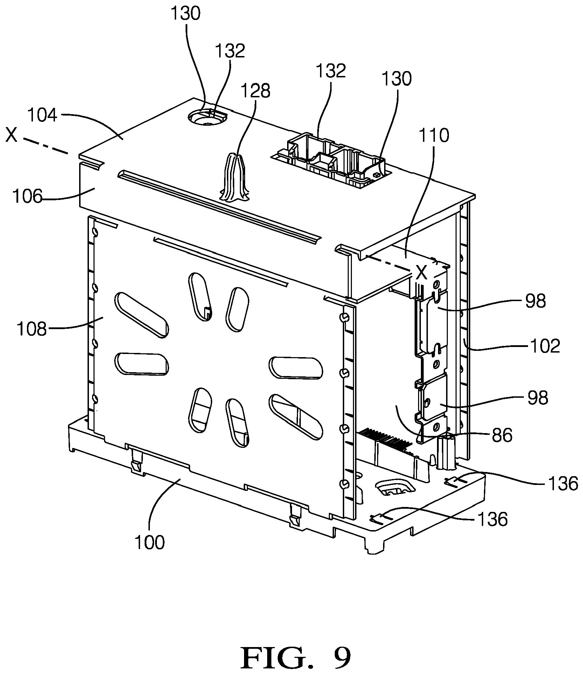

Referring to Figure 9, the fifth step of folding the preform blank 84 entails manually or mechanically rotating top closure wall portion 106 substantially 90° about axis X - X from its horizontal orientation illustrated in Figure 8 co-planer with the bottom wall portion 102 to a vertical orientation substantially parallel and coplanar with top wall portion 108. During this step, each male guide feature 114 self-positions and self-engages with an associated female guide feature 112 to retain the folded preform blank 84 as illustrated in Figure 9. As illustrated in Figure 9, the preform blank 84 has been fully folded into a three-dimensional box-like configuration.

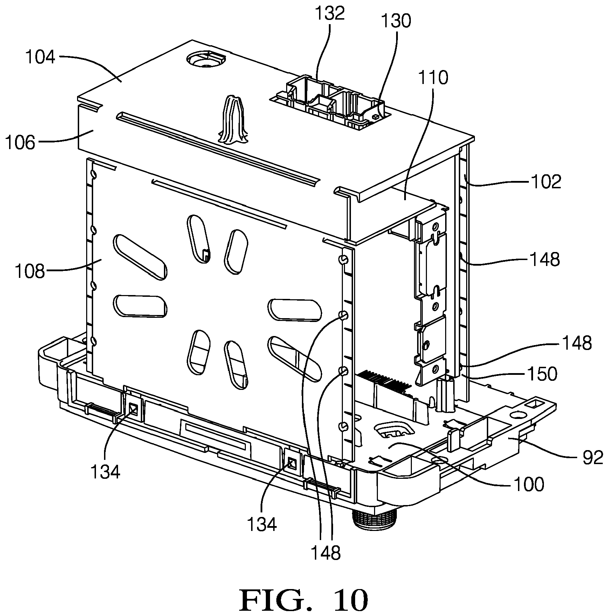

Referring to Figure 10, the trim plate subassembly 92 can be affixed to the outer (bottom as depicted) surface of the front wall portion 100 by self-aligning, self-engaging engagement features 134. The inner surface of the bottom wall portion 102 defines four integrally formed grounding clips.

Note that during the process of forming the preform blank 84, the screen can be stretched, punched or weakened in certain contoured areas. Extra screen inserts can be provided within such portions of the mold or external EMI patches or surface coatings can be provided to ensure complete shielding is provided by the final assembly.

The wire screen/conductive layer is continuous throughout the full extent of the six contiguous wall portions 100, 102, 104, 106, 108 and 110, with the exception of where the leading edge of the top closure wall portion 106 adjoins the trailing edge of the shield wall portion 110, and where the leading edge of the shield wall portion 110 adjoins the upper surface of the circuit board assembly 86. Any slight gap at the points of contact of the shield wall portion 110 with the top closure wall portion 106 and the circuit board assembly 86 is believed by the inventors to result in only diminimus RF leakage that is largely mitigated by the present invention.

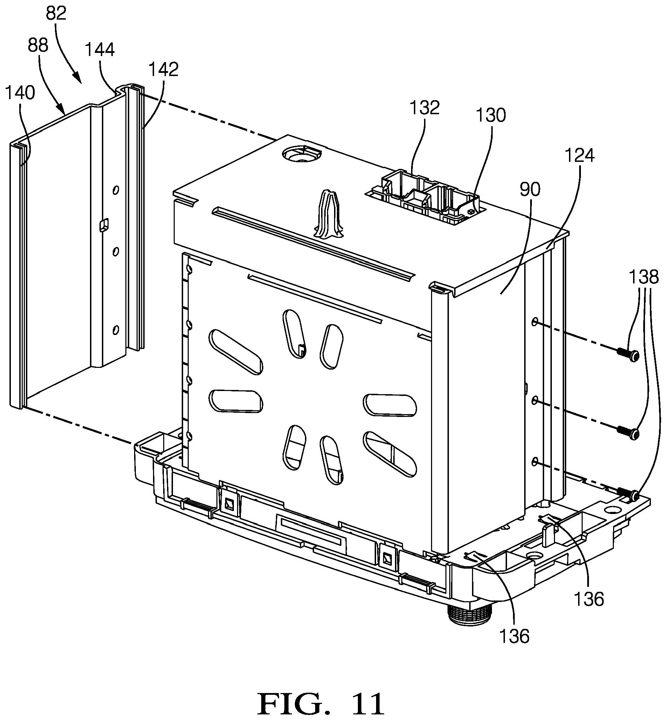

Referring to Figure 11, the application of the left and right side closure members 88 and 90 is illustrated as the sixth step. The rear edge portions of the closure members88 and 90 are initially angularly positioned under their respective retention rib 124 and then pivoted thereabout to assume the final, installed position illustrated in Figure 11. As the side closure members 88 and 90 are fully installed, the forward edges thereof are retained in the installed position by self-engaging retention features 136 integrally formed on the rear surface of the front wall portion 100. Thereafter, screws 138 are applied through holes in the right side closure member 90 to engage their respective power devices 98 to establish the right side closure member 2020 as a heat sink, as well as a portion of the EMC, RFI, BCI and ESD shielding for the audio system 82. After this step, final assembly is essentially complete.

As best viewed in Figure 11, the side closure members 88 and 90 are identical, formed from a continuous extrusion process, having a typical cross-section defining inwardly directed upper channels 140, lower channels 142 and center channels 144. During installation, each upper channel 140 forms an interference fit with a respective edge portion of the top wall portion 108. Similarly, each lower channel 144 forms an interference fit with a respective edge portion of the bottom wall portion 86.

The circuit board subassembly 86 consists of a printed circuit board (PCB) 146 and comprises an audio component.

The trim plate subassembly 92 is configured to organize audio system input/output and display devices, informational indicia and decorative display devices for an associated host vehicle operator.

The preform blank 84 is formed of a composite of relatively rigid polymer material and electrically conductive material operable to shield the audio components (such as the circuit board subassembly 146 from electrical anomalies including radio frequency interference (RFI), electromagnetic interference (EMI), bulk current injection (BCI) and electrostatic discharge (ESD). The electrically conductive material comprises substantially continuous planer sheet portions applied to surfaces of or within polymer housing assembly wall portions as discrete elements, electrically conductive paint, foil or electrostatic or vacuum deposition applied material. Alternatively, the electrically conductive material comprises a wire mesh screen which has been cut and folded to net shape and inserted within a mold cavity whereby it is effectively insert molded within the polymer based material. Preferably, the wire screen is centered within the wall portions of the case and front plate whereby electrically insulating polymer material effectively covers the wire screen, both inside and out, to prevent inadvertent grounding of the housing assembly to interior or exterior structures.

The circuit board is grounded to the molded in wire mesh by using a grounding clip that contacts the ground plane on the circuit board to the metal mesh by pressing the circuit board with the clip installed into a hole or recess in the plastic box that exposes the mesh. A point/ridge/protuberance is used on the clip to press into the mesh and increase the pressure for intimate contact. An alternative of this clip is one that gets surface mounted and soldered to the board and does not require manual assembly.

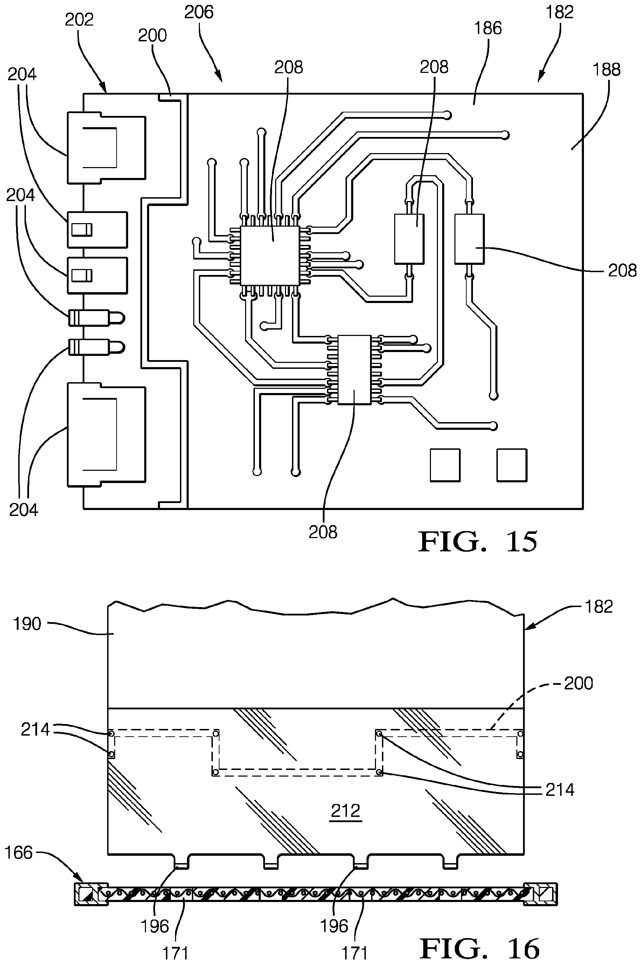

One form of grounding the circuit board subassembly 86 to the wire screen beryllium copper grounding clips, which are electrically and mechanically connected to a ground146. Referring to Figures 32 - 38, alternative forms of grounding the ground plane 216 of the circuit board subassembly 64 to the wire screen are illustrated. Figure 133 illustrates a radio/CD player 622 similar in all material respects to the radio/CD player 62 described hereinabove in connection with Figures 2 - 10 and 15 - 20 inter alia, with the exceptions described immediately hereinbelow. In essence, in this embodiment, the four ground clips 218 contained on the circuit board subassembly 64 are deleted and replaced by connectors integrally formed with the housing assembly 76.

Using the molded in metal mesh in the receiver plastic box that is grounded to the circuit boards creates a Faraday cage that provides shielding protection for RFI (Radio Frequency Interference), EMI (Electro Magnetic Interference), BCI (Bulk Current Injection), and ESD (Electrostatic Discharge).

Referring to Figure 10, the exposed edges or alternatively, a molded rail, of the top wall portion 108 and bottom wall portion 102 have a series of openings 148 exposing the electrically conductive screen 150. The exposed segments of screen 150 have an upward/downward extending dome or distension locally raising the screen above the outer surface of the adjacent wall portion. Once installed, the inner surfaces of the channels 140 and 142 compressively engage the screen domes to establish reliable, multi-point electrical contact therebetween.

Adjacent edges of wall portions are slightly spaced apart to expose electrically conductive material such as screen 150 extending along the respective living hinge axis. This arrangement assures that each of the wall panels remain substantially rigid while the hinge portions are relatively flexible, and maintains its EMI isolation characteristics. Preferably, at each end of each living hinge is a relatively thin web of plastic integrally interconnecting the adjacent wall portions to provide torsional rigidity to the hinge, as well as the overall housing assembly.

Referring to Figures 13 and 14, the housing panel covering the connector area is folded at the bottom (i.e., below the circuit board) instead of at the top (i.e., above the circuit board) as illustrated in Figure 12. The configuration of Figures 13 and 14 incorporated mesh-to-PCB contacts along the edge of the PCB in the connector area.

Referring to Figure 14, an electrical assembly 152 includes a box-like case 154 includes a top wall panel 156 integrally joined with a rear wall panel 158 by a living hinge 160. The rear wall panel 158 is also integrally joined with a bottom wall panel 162 by a living hinge 164. The bottom wall panel 162 is also integrally joined with a front wall panel 166 by a living hinge 168. The wall panels 156, 158, 162 and 166 are serially conjoined by the living hinges 160, 164 and 168, respectively, and are preferably formed from a generally planar preform blank consisting of at least one layer 170 of relatively rigid polymer material and at least one layer 171 of electrically conductive material (e.g., wire mesh). Referring to Figure 13, the wall panels 156, 158, 162 and 166 are folded at right angles to define an enclosure 176 closed by a left side wall 172 and a right side wall 174 (or closure members). A trailing free edge 178 of the top panel 156 is closely positioned adjacent a leading free edge 180 of the front panel 166 when fully folded, forming a slight opening 181 there between.

An electric circuit assembly 182 is supported within the enclosure 176 by retainer features 184 integrally formed on the inner surfaces of the rear and front wall panels 158 and 166, respectively. The electric circuit assembly 182 includes a generally planer substrate 186 (e.g., printed circuit board) having an upper surface 188, a lower surface 190, and edge surfaces. Grounding pads 194 are formed on the lower surface 190, and contact pads 196 are formed on selective edge surfaces 192 of the substrate 186. The grounding pads 194 are grounded to the conductive layer 171 by a spring clip 198, and contact pads 196 are directly grounded to a locally exposed area of conductive layer 171.

The substrate 186 is bifurcated by an electrically conductive barrier 200 separating the upper surface 188 into a connector region 202 supporting all of the connectors 204 serving to interface the electrical assembly 152 with outside circuit systems, and a circuit region 206 supporting all active, passive and conductive circuit elements 208 which may be sensitive to electrical anomalies. The electrically conductive barrier 200 extends laterally the entire distance between the side wall panels 172 and 174, and vertically the entire distance between the upper surface 188 of the substrate 186 and the top wall panel 156, making electrical contact with an exposed region of conductive material 171. In assembly, the connectors 204 extend outwardly through openings 210 formed in the front wall panel 166.

A ground plane 212 is carried on the lower surface 190 of the substrate 186 extending laterally the entire distance between the side wall panels 172 and 174, and electrically interconnected there with, and longitudinally the entire distance between the front wall panel 166 and the electrically conductive barrier 200. Restated, the ground plane 212 extends coincidentally with the connector region 202.

Referring to Figures 14 - 16, the electrically conductive barrier 200 is mounted by local placement pins 214 extending through the substrate 186 and electrically and mechanically interconnected with the ground plane 212 such as by soldering.

As best illustrated in Figure 14, the electrical assembly 152 effectively forms a completely closed Faraday shield 216 (illustrated by a continuous dotted line) consisting of the continuous conductive material 171 within (a portion of) the top wall panel 156, the back wall panel 158, the bottom wall panel 162, (a portion of the) front wall panel 166, the electrically conductive barrier 200 and the ground plane 202. Although the connector region 202 is also shielded by continuous conductive material 171 within (a portion of) the top wall panel 156 and (a portion of) the front wall panel 166, it is entirely exterior of the enclosure 176 protected by the Faraday shield 216.

It is to be understood that the invention has been described with reference to specific embodiments and variations to provide the features and advantages previously described and that the embodiments are susceptible of modification as will be apparent to those skilled in the art.

Furthermore, it is contemplated that many alternative, common inexpensive materials can be employed to construct the basis constituent components. Accordingly, the forgoing is not to be construed in a limiting sense.

The invention has been described in an illustrative manner, and it is to be understood that the terminology, which has been used is intended to be in the nature of words of description rather than of limitation.

Obviously, many modifications and variations of the present invention are possible in light of the above teachings. For example, a number of the various radio case constructions illustrated herein are illustrated as being formed of solid molded polymer material for the sake of simplicity and clarity of understanding. It is to be understood, however, that the wire mesh depicted can be employed in the other configurations and embodiments with equal success. Furthermore, several of the housing assembly structures are described herein as being formed of metal. However, a wide range of material substitutes, including plastics, ceramics, non-ferrous metals and composites can be substituted without departing from the spirit and scope of the present invention. The terms "snap-engaging" and "self-engaging" are intended to interpreted very broadly inasmuch as innumerable structural, process (e.g. weldments) and chemical (e.g. adhesives) equivalents are available. It is, therefore, to be understood that within the scope of the appended claims, wherein reference numerals are merely for illustrative purposes and convenience and are not in any way limiting, the invention, which is defined by the following claims as interpreted according to the principles of patent law, including the Doctrine of Equivalents, may be practiced otherwise than is specifically described.

## Claims

1. An electrical assembly (152) comprising:
a box-like case (154) having at least four wall panels (156) serially conjoined by living hinges (160) extending between adjacent pairs of said wall panels (156) and at least one discrete closure member cooperatively enclosing at least one electrical circuit assembly,
wherein said at least four wall panels (156) are integrally formed from a generally planer composite preform blank (84) consisting of at least one layer (170) of relatively rigid polymer material and at least one layer (170) of electrically conductive material (171) capable of shielding said electrical circuit assembly from electrical anomalies,
wherein said electrical circuit assembly includes a substrate (186) bifurcated by an electrically conductive barrier (200) forming a connector region (202) and a circuit region (206), said barrier segregating circuit connectors (204) from circuit elements sensitive to said anomalies,
wherein said electrical circuit assembly includes a ground plane extending coincidentally with said connector region (202) and electrically interconnected with said barrier and said layer of electrically conductive material (171), forming a faraday shield (216) enclosing said circuit region (206);
**characterized in that** said electrically conductive barrier (200) comprises a fifth wall panel serially conjoined to one of said at least four wall panels (156) by an interconnecting living hinge (160) and electrically interconnected with said ground plane.

2. The electrical assembly (152) of claim 1, wherein all interface devices operative to interconnect said circuit elements with external electrical systems are disposed within said connector region (202).

3. The electrical assembly (152) of claim 1 or 2, wherein said barrier is electrically interconnected with both said ground plane and said layer of electrically conductive material (171).

4. The electrical assembly (152) of any of claims 1 to 3, wherein said at least four wall portions comprise a front wall portion (100), top and bottom wall portions and a rear wall portion (104).

5. The electrical assembly (152) of any of claims 1 to 4, further comprising respective pairs of cooperating engagement features integrally formed with said preform blank (84) to retain said case in a three-dimensional configuration.

6. The electrical assembly (152) of claims 4 and 5, wherein said front, top, bottom and rear wall portions each define a leading edge, a trailing edge and opposed side edges,
wherein at least one of said engagement features are integrally formed on an inner surface of said front wall portion (100) adjacent said front wall portion (100) leading edge,
wherein the trailing edge of said front wall portion (100) is integrally interconnected to the leading edge of said top or bottom wall portion (102) by a first living hinge,
wherein the trailing edge of said top or bottom wall portion (102) is integrally interconnected to the leading edge of said rear wall portion (104) by a second living hinge,
wherein the trailing edge of said rear wall portion (104) is integrally interconnected to the leading edge of the other of said top or bottom wall portion (102) by a third living hinge, and
wherein the trailing edge of the other of said top or bottom wall portion (102) integrally forms a cooperating engagement feature operative to lockingly engage the engagement feature of said front wall portion (100).

7. The electrical assembly (152) of claim 6, wherein said living hinges (160) each comprise a continuous portion of said layer of electrically conductive material (171) integrally bridging said adjacent wall portions.

8. The electrical assembly (152) of claim 6 or 7, wherein said living hinge (160) comprises a segment of said layer of polymer material integrally bridging said adjacent wall portions.

9. A method of fabricating an electrical assembly (152) including a box-like case (154) having at least four wall portions and at least one discrete closure member cooperatively enclosing at least one electrical circuit assembly, said method comprising the steps of:
forming a generally planer composite preform blank (84) consisting of at least one layer (170) of relatively rigid polymer material and at least one layer (170) of electrically conductive material (171) capable of shielding said electrical circuit assembly from electrical anomalies,
wherein said preform blank (84) defines said wall portions which are integrally formed on a common plane and are interconnected by living hinges (160) extending between adjacent pairs of said wall portions;
forming said electrical circuit assembly with a substrate (186) bifurcated by an electrically conductive barrier (200) forming a connector region (202) and a circuit region (206), said barrier segregating circuit connectors (204) from circuit elements sensitive to said anomalies;
wherein said electrically conductive barrier (200) comprises a fifth wall panel serially conjoined to one of said at least four wall panels (156) by an interconnecting living hinge (160) and electrically interconnected with a ground plane;
forming said electrical circuit assembly with said ground plane extending coincidentally with said connector region (202) and electrically interconnected with said barrier and said layer of electrically conductive material (171);
affixing said electrical circuit assembly to one of said preform wall portions;
folding said preform wall portions at respective right angles to form said case;
affixing respective pairs of cooperating engagement features integrally formed on said perform blank (84) to retain said case in a three-dimensional configuration; and
affixing said closure member to four contiguous wall portion edges to effect closure of said case.

10. The method of claim 9, further comprising the step of forming the electrically conductive material (171) layer of said preform blank (84) from a single sheet of wire screen (150).

11. The method of claim 10, further comprising the step of forming the preform blank (84) by insert molding the wire screen (150) substantially within said polymer material.

12. The method of any of claims 9 to 11, wherein the step of folding said preform panels comprises serially displacing each of said pairs of adjacent panels from a generally planer configuration to a substantially normal configuration about an axis defined by an associated living hinge (160) to form said box-like case (154).

13. The method of any of claims 9 to 12, further comprising the step of thermally affixing at least one power device carried with said circuit assembly to said closure member to effect ambient heat dissipation therefrom.

14. The method of any of claims 9 to 13, further comprising the step of forming said closure member from electrically conductive material (171), wherein said step of affixing said closure member to said folded preform wall portions effects electrical interconnection of the closure member with the electrically conductive material (171) contained with the preform blank (84).

15. The method of claim 14, wherein said step of forming said closure member comprises serially cutting a plurality of substantially identical closure members from a continuously formed extruded aluminum billet.

16. The method of any of claims 9 to 15, wherein said step of affixing said closure member comprises affixing said closure member to said four contiguous wall portion edges to effect closure of one opening of said case, and affixing a second closure member to a second grouping of four contiguous wall portion edges to effect closure of a second opening of said case.

17. The method of any of claims 9 to 16, further comprising the step of affixing an operator accessible trim panel to an exterior surface of one of said wall portions.

## Patentansprüche

1. Elektrische Anordnung (152), die aufweist:
ein kastenartiges Gehäuse (154) mit zumindest vier Wandplatten (156), die durch Biegescharniere (160) seriell verbunden sind, die sich zwischen angrenzenden Paaren der Wandplatten (156) erstrecken, und zumindest einem diskreten Schließelement, das kooperativ zumindest eine elektrische Schaltungsanordnung umschließt,
wobei die zumindest vier Wandplatten (156) integral aus einem im Allgemeinen ebenen Verbundvorformrohling (84) gebildet sind, der aus zumindest einer Schicht (170) aus relativ starrem Polymermaterial und zumindest einer Schicht (170) aus elektrisch leitendem Material (171) besteht, fähig zum Abschirmen der elektrischen Schaltungsanordnung gegen elektrische Anomalien,
wobei die elektrische Schaltungsanordnung ein Substrat (186) umfasst, das durch eine elektrisch leitende Barriere (200) gabelförmig geteilt ist, die einen Verbinderbereich (202) und einen Schaltungsbereich (206) bildet, wobei die Barriere Schaltungsverbinder (204) von Schaltungselementen trennt, die für die Anomalien anfällig sind,
wobei die elektrische Schaltungsanordnung eine Masseebene umfasst, die sich koinzident mit dem Verbinderbereich (202) erstreckt und elektrisch mit der Barriere und der Schicht aus elektrisch leitendem Material (171) verbunden ist, eine Faraday-Abschirmung (216) bildend, die den Schaltungsbereich (206) umschließt;
**dadurch gekennzeichnet, dass** die elektrisch leitende Barriere (200) eine fünfte Wandplatte aufweist, die seriell mit einer der zumindest vier Wandplatten (156) durch ein verbindendes Biegescharnier (160) verbunden ist und mit der Masseebene elektrisch verbunden ist.

2. Die elektrische Anordnung (152) gemäß Anspruch 1, wobei alle Schnittstellenvorrichtungen, die betriebsfähig sind zum Verbinden der Schaltungselemente mit externen elektrischen Systemen, in dem Verbinderbereich (202) angeordnet sind.

3. Die elektrische Anordnung (152) gemäß Anspruch 1 oder 2, wobei die Barriere sowohl mit der Masseebene als auch der Schicht aus elektrisch leitendem Material (171) elektrisch verbunden ist.

4. Die elektrische Anordnung (152) gemäß einem der Ansprüche 1 bis 3, wobei die zumindest vier Wandteile einen vorderen Wandteil (100), obere und untere Wandteile und einen hinteren Wandteil (104) aufweisen.

5. Die elektrische Anordnung (152) gemäß einem der Ansprüche 1 bis 4, die weiter jeweilige Paare von kooperierenden Eingriffsmerkmalen aufweist, die integral mit dem Vorformrohling (84) ausgebildet sind, um das Gehäuse in einer dreidimensionalen Konfiguration zu halten.

6. Die elektrische Anordnung (152) gemäß den Ansprüchen 4 und 5, wobei der vordere, obere, untere und hintere Wandteil jeweils eine Vorderkante, eine Hinterkante und gegenüberliegende Seitenkanten definieren,
wobei zumindest eines der Eingriffsmerkmale integral an einer Innenfläche des vorderen Wandteils (100) angrenzend an die Vorderkante des vorderen Wandteils (100) ausgebildet ist,
wobei die Hinterkante des vorderen Wandteils (100) integral mit der Vorderkante des oberen oder unteren Wandteils (102) durch ein erstes Biegescharnier verbunden ist,
wobei die Hinterkante des oberen oder unteren Wandteils (102) integral mit der Vorderkante des hinteren Wandteils (104) durch ein zweites Biegescharnier verbunden ist,
wobei die Hinterkante des hinteren Wandteils (104) integral mit der Vorderkante des anderen des oberen oder unteren Wandteils (102) durch ein drittes Biegescharnier verbunden ist, und
wobei die Hinterkante des anderen des oberen oder unteren Wandteils (102) integral ein kooperierendes Eingriffsmerkmal bildet, das betriebsfähig ist, um das Eingriffsmerkmal des vorderen Wandteils (100) verriegelnd in Eingriff zu bringen.

7. Die elektrische Anordnung (152) gemäß Anspruch 6, wobei die Biegescharniere (160) jeweils einen kontinuierlichen Teil der Schicht aus elektrisch leitendem Material (171) aufweisen, der die angrenzenden Wandteile integral überbrückt.

8. Die elektrische Anordnung (152) gemäß Anspruch 6 oder 7, wobei das Biegescharnier (160) ein Segment der Schicht aus Polymermaterial aufweist, das die angrenzenden Wandteile integral überbrückt.

9. Ein Verfahren zum Herstellen einer elektrischen Anordnung (152) mit einem kastenartigen Gehäuse (154) mit zumindest vier Wandteilen und zumindest einem diskreten Schließelement, das kooperativ zumindest eine elektrische Schaltungsanordnung umschließt, wobei das Verfahren die Schritte aufweist:
Bilden eines im Allgemeinen ebenen Verbundvorformrohlings (84), der aus zumindest einer Schicht (170) aus relativ starrem Polymermaterial und zumindest einer Schicht (170) aus elektrisch leitendem Material (171) besteht, fähig zum Abschirmen der elektrischen Schaltungsanordnung gegen elektrische Anomalien,
wobei der Vorformrohling (84) die Wandteile definiert, die integral auf einer gemeinsamen Ebene gebildet sind und durch Biegescharniere (160), die sich zwischen angrenzenden Paaren der Wandteile erstrecken, miteinander verbunden sind;
Bilden der elektrischen Schaltungsanordnung mit einem Substrat (186), das durch eine elektrisch leitende Barriere (200) gabelförmig geteilt ist, die einen Verbinderbereich (202) und einen Schaltungsbereich (206) bildet, wobei die Barriere Schaltungsverbinder (204) von Schaltungselementen trennt, die für die Anomalien anfällig sind;
wobei die elektrisch leitende Barriere (200) eine fünfte Wandplatte aufweist, die seriell mit einer der zumindest vier Wandplatten (156) durch ein verbindendes Biegescharnier (160) verbunden ist und mit einer Masseebene elektrisch verbunden ist;
Bilden der elektrischen Schaltungsanordnung mit der Masseebene, die sich koinzident mit dem Verbinderbereich (202) erstreckt und mit der Barriere und der Schicht aus elektrisch leitendem Material (171) elektrisch verbunden ist;
Befestigen der elektrischen Schaltungsanordnung an einem der Vorformwandteile;
Falten der Vorformwandteile in jeweiligen rechten Winkeln, um das Gehäuse zu bilden;
Befestigen jeweiliger Paare von kooperierenden Eingriffsmerkmalen, die integral an dem Vorformrohling (84) ausgebildet sind, um das Gehäuse in einer dreidimensionalen Konfiguration zu halten; und
Befestigen des Schließelements an vier aneinandergrenzenden Wandteilkanten, um ein Schließen des Gehäuses zu bewirken.

10. Das Verfahren gemäß Anspruch 9, das weiter den Schritt eines Bildens der Schicht aus elektrisch leitendem Material (171) des Vorformrohlings (84) aus einer einzelnen Lage eines Drahtgeflechts (150) aufweist.

11. Das Verfahren gemäß Anspruch 10, das weiter den Schritt eines Bildens des Vorformrohlings (84) durch Umspritzen des Drahtgeflechts (150) im Wesentlichen in dem Polymermaterial aufweist.

12. Das Verfahren gemäß einem der Ansprüche 9 bis 11, wobei der Schritt des Faltens der Vorformplatten ein serielles Versetzen jedes der Paare von angrenzenden Platten aus einer im Allgemeinen ebenen Konfiguration in eine im Wesentlichen normale Konfiguration um eine durch ein assoziiertes Biegescharnier (160) definierte Achse aufweist, um das kastenartige Gehäuse (154) zu bilden.

13. Das Verfahren gemäß einem der Ansprüche 9 bis 12, das weiter den Schritt eines thermischen Befestigens zumindest einer Leistungsvorrichtung, die mit der Schaltungsanordnung getragen wird, an dem Schließelement aufweist, um eine Umgebungswärmeableitung davon zu bewirken.

14. Das Verfahren gemäß einem der Ansprüche 9 bis 13, das weiter den Schritt eines Bildens des Schließelements aus elektrisch leitendem Material (171) aufweist, wobei der Schritt des Befestigens des Schließelements an den gefalteten Vorformwandteilen eine elektrische Verbindung des Schließelements mit dem elektrisch leitendes Material (171) bewirkt, das in dem Vorformrohling (84) enthalten ist.

15. Das Verfahren gemäß Anspruch 14, wobei der Schritt des Bildens des Schließelements ein serielles Schneiden einer Vielzahl von im Wesentlichen identischen Schließelementen aus einem kontinuierlich gebildeten extrudierten Aluminiumblock aufweist.

16. Das Verfahren gemäß einem der Ansprüche 9 bis 15, wobei der Schritt des Befestigens des Schließelements ein Befestigen des Schließelements an den vier angrenzenden Wandteilkanten aufweist, um ein Schließen einer Öffnung des Gehäuses zu bewirken, und ein Befestigen eines zweiten Schließelements an einer zweiten Gruppierung von vier angrenzenden Wandteilkanten, um ein Schließen einer zweiten Öffnung des Gehäuses zu bewirken.

17. Das Verfahren gemäß einem der Ansprüche 9 bis 16, das weiter den Schritt eines Befestigens einer für einen Bediener zugänglichen Verkleidungsplatte an einer Außenfläche eines der Wandteile aufweist.

## Revendications

1. Ensemble électrique (152) comprenant :
un boîtier (154) semblable à une boîte ayant au moins quatre panneaux de paroi (156) joints en série par des charnières vives (160) s'étendant entre des paires adjacentes desdits panneaux de paroi (156) et au moins un élément de fermeture discret enfermant par coopération au moins un ensemble formant circuit électrique,
dans lequel lesdits au moins quatre panneaux de paroi (156) sont formés d'un seul tenant à partir d'une ébauche de préforme composite (84) généralement plane constituée d'au moins une couche (170) de matériau polymère relativement rigide et d'au moins une couche (170) de matériau électriquement conducteur (171) capable de blinder ledit ensemble formant circuit électrique contre les anomalies électriques,
dans lequel ledit ensemble formant circuit électrique inclut un substrat (186) divisé par une barrière électriquement conductrice (200) formant une région de connecteurs (202) et une région de circuit (206), ladite barrière séparant des connecteurs de circuit (204) d'éléments de circuit sensibles auxdites anomalies,
dans lequel ledit ensemble formant circuit électrique inclut un plan de masse s'étendant en coïncidence avec ladite région de connecteurs (202) et relié électriquement à ladite barrière et ladite couche de matériau électriquement conducteur (171), formant une cage de Faraday (216) enfermant ladite région de circuit (206) ;
**caractérisé en ce que** ladite barrière électriquement conductrice (200) comprend un cinquième panneau de paroi joint en série à l'un desdits au moins quatre panneaux de paroi (156) par une charnière vive d'interconnexion (160) et relié électriquement audit plan de masse.

2. Ensemble électrique (152) selon la revendication 1, dans lequel tous les dispositifs interface dont la fonction est d'interconnecter lesdits éléments de circuit à des systèmes électriques externes sont disposés à l'intérieur de ladite région de connecteurs (202).

3. Ensemble électrique (152) selon la revendication 1 ou 2, dans lequel ladite barrière est reliée électriquement à la fois audit plan de masse et à ladite couche de matériau électriquement conducteur (171).

4. Ensemble électrique (152) selon l'une quelconque des revendications 1 à 3, dans lequel lesdites au moins quatre parties formant paroi comprennent une partie formant paroi avant (100), des parties formant parois supérieure et inférieure et une partie formant paroi arrière (104).

5. Ensemble électrique (152) selon l'une quelconque des revendications 1 à 4, comprenant en outre des paires respectives d'éléments d'engagement coopérants formés d'un seul tenant avec ladite ébauche de préforme (84) pour maintenir ledit boîtier dans une configuration tridimensionnelle.

6. Ensemble électrique (152) selon les revendications 4 et 5, dans lequel lesdites parties formant paroi avant, supérieure, inférieure et arrière définissent chacune un bord avant, un bord arrière et des bords latéraux opposés,
dans lequel au moins un desdits éléments d'engagement est formé d'un seul tenant sur une surface intérieure de ladite partie formant paroi avant (100) adjacente audit bord avant de la partie formant paroi avant (100),
dans lequel le bord arrière de ladite partie formant paroi avant (100) est relié d'un seul tenant au bord avant de ladite partie formant paroi supérieure ou inférieure (102) par une première charnière vive,
dans lequel le bord arrière de ladite partie formant paroi supérieure ou inférieure (102) est relié d'un seul tenant au bord avant de ladite partie formant paroi arrière (104) par une deuxième charnière vive,
dans lequel le bord arrière de ladite partie formant paroi arrière (104) est relié d'un seul tenant au bord avant de l'autre de ladite partie formant paroi supérieure ou inférieure (102) par une troisième charnière vive, et
dans lequel le bord arrière de l'autre de ladite partie formant paroi supérieure ou inférieure (102) forme d'un seul tenant un élément d'engagement coopérant apte à coopérer par verrouillage avec l'élément d'engagement de ladite partie formant paroi avant (100).

7. Ensemble électrique (152) selon la revendication 6, dans lequel lesdites charnières vives (160) comprennent chacune une partie continue de ladite couche de matériau électriquement conducteur (171) qui forme un pontage intégral desdites parties formant parois adjacentes.

8. Ensemble électrique (152) selon la revendication 6 ou 7, dans lequel ladite charnière vive (160) comprend un segment de ladite couche de matériau polymère qui forme un pontage intégral desdites parties formant parois adjacentes.

9. Procédé de fabrication d'un ensemble électrique (152) incluant un boîtier (154) semblable à une boîte ayant au moins quatre parties formant paroi et au moins un élément de fermeture discret enfermant par coopération au moins un ensemble formant circuit électrique, ledit procédé comprenant les étapes consistant à :
former une ébauche de préforme composite (84) généralement plane constituée d'au moins une couche (170) de matériau polymère relativement rigide et d'au moins une couche (170) de matériau électriquement conducteur (171) capable de blinder ledit ensemble formant circuit électrique contre des anomalies électriques,
dans lequel ladite ébauche de préforme (84) définit lesdites parties formant paroi qui sont formées d'un seul tenant sur un plan commun et sont reliées par des charnières vives (160) s'étendant entre des paires adjacentes desdites parties formant paroi ;
former ledit ensemble formant circuit électrique avec un substrat (186) divisé par une barrière électriquement conductrice (200) formant une région de connecteurs (202) et une région de circuit (206), ladite barrière séparant des connecteurs circuit (204) d'éléments de circuit sensibles auxdites anomalies ;
dans lequel ladite barrière électriquement conductrice (200) comprend un cinquième panneau de paroi joint en série à l'un desdits au moins quatre panneaux de paroi (156) par une charnière vive d'interconnexion (160) et relié électriquement à un plan de masse ;
former ledit ensemble formant circuit électrique avec ledit plan de masse s'étendant en coïncidence avec ladite région de connecteurs (202) et relié électriquement à ladite barrière et à ladite couche de matériau électriquement conducteur (171) ;
fixer ledit ensemble formant circuit électrique à l'une desdites parties formant paroi de préforme ;
plier lesdites parties formant paroi de préforme à des angles droits respectifs pour former ledit boîtier ;
fixer des paires respectives d'éléments d'engagement coopérants formés d'un seul tenant sur ladite ébauche de préforme (84) pour maintenir ledit boîtier dans une configuration tridimensionnelle , et
fixer ledit élément de fermeture à quatre bords de partie formant paroi contigus pour effectuer la fermeture dudit boîtier.

10. Procédé selon la revendication 9, comprenant en outre l'étape consistant à former la couche de matériau électriquement conducteur (171) de ladite ébauche de préforme (84) à partir d'une seule feuille de toile métallique (150).

11. Procédé selon la revendication 10, comprenant en outre l'étape consistant à former l'ébauche de préforme (84) par moulage sur insert de la toile métallique (150) sensiblement à l'intérieur dudit matériau polymère.

12. Procédé selon l'une quelconque des revendications 9 à 11, dans lequel l'étape de pliage desdits panneaux de préforme consiste à faire passer en série chacune desdites paires de panneaux adjacents d'une configuration généralement plane à une configuration sensiblement normale autour d'un axe défini par une charnière vive (160) associée pour former ledit boîtier (154) semblable à une boîte.

13. Procédé selon l'une quelconque des revendications 9 à 12, comprenant en outre l'étape consistant à fixer thermiquement au moins un dispositif de puissance porté par ledit ensemble formant circuit sur ledit élément de fermeture pour effectuer une dissipation de chaleur dans le milieu ambiant à partir de celui-ci.

14. Procédé selon l'une quelconque des revendications 9 à 13, comprenant en outre l'étape consistant à former ledit élément de fermeture à partir du matériau électriquement conducteur (171), dans lequel ladite étape de fixation dudit élément de fermeture auxdites parties formant paroi de préforme pliées effectue une liaison électrique de l'élément de fermeture avec le matériau électriquement conducteur (171) contenu dans l'ébauche de préforme (84).

15. Procédé selon la revendication 14, dans lequel ladite étape de formation dudit élément de fermeture consiste à découper en série une pluralité d'éléments de fermeture sensiblement identiques à partir d'une billette d'aluminium extrudé formée en continu.

16. Procédé selon l'une quelconque des revendications 9 à 15, dans lequel ladite étape de fixation dudit élément de fermeture consiste à fixer ledit élément de fermeture auxdits quatre bords de parties formant parois contigus pour effectuer la fermeture d'une ouverture dudit boîtier, et à fixer un second élément de fermeture à un second groupe de quatre bords de parties formant parois contigus pour effectuer la fermeture d'une seconde ouverture dudit boîtier.

17. Procédé selon l'une quelconque des revendications 9 à 16, comprenant en outre l'étape consistant à fixer un panneau de garniture accessible par un opérateur à une surface extérieure de l'une desdites parties formant parois.
